(19) Europäisches Patentamt
European Patent Office
Office européen des brevets

(11) **EP 2 984 455 B1**

(12) **EUROPÄISCHE PATENTSCHRIFT**

(45) Veröffentlichungstag und Bekanntmachung des Hinweises auf die Patenterteilung:
**05.12.2018 Patentblatt 2018/49**

(21) Anmeldenummer: **14709312.4**

(22) Anmeldetag: **12.03.2014**

(51) Int Cl.:
**G01D 5/14** (2006.01)

(86) Internationale Anmeldenummer:
**PCT/EP2014/054779**

(87) Internationale Veröffentlichungsnummer:
**WO 2014/166689 (16.10.2014 Gazette 2014/42)**

(54) **MAGNETFELDSENSORVORRICHTUNG, BETÄTIGUNGSVORRICHTUNG UND VERFAHREN ZUR BESTIMMUNG EINER RELATIVPOSITION**

MAGNETIC FIELD SENSOR APPARATUS, OPERATING APPARATUS AND METHOD FOR DETERMINING A RELATIVE POSITION

DISPOSITIF DE DÉTECTION DE CHAMP MAGNÉTIQUE, DISPOSITIF DE COMMANDE ET PROCÉDÉ DE DÉTERMINATION D'UNE POSITION RELATIVE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.04.2013 DE 102013206518**

(43) Veröffentlichungstag der Anmeldung:
**17.02.2016 Patentblatt 2016/07**

(73) Patentinhaber: **ZF Friedrichshafen AG**
**88046 Friedrichshafen (DE)**

(72) Erfinder: **KERNEBECK, Bernd**
**49152 Bad Essen (DE)**

(56) Entgegenhaltungen:
**EP-A1- 0 175 061        EP-A1- 1 132 717**
**DE-A1-102007 052 146    DE-A1-102008 037 080**

**EP 2 984 455 B1**

## Beschreibung

Die vorliegende Erfindung bezieht sich auf eine Tastenschaltvorrichtung für ein Fahrzeug sowie auf ein Verfahren zur Bestimmung einer Relativposition zwischen einer ersten Komponente und einer zweiten Komponente, die beispielsweise im Zusammenhang mit Auswahltasten zur Auswahl einer Getriebestufe eines Fahrzeugs eingesetzt werden können.

Zur Erfassung einer Relativposition zwischen zwei Komponenten können Magnetfeldsensoren eingesetzt werden. Dabei kann eine Gebereinheit, mit der ein magnetisches Feld erzeugt wird, an einer ersten der Komponenten und eine Sensoreinheit zum Auswerten des magnetischen Felds an einer zweiten der Komponenten angeordnet sein.

Die EP 1 777 501 A1 offenbart eine Positionssensoranordnung zur berührungslosen Positionsbestimmung mittels redundanter magnetempfindlicher Sensorelemente.

Die europäische Patentanmeldung EP 0 175 061 offenbart einen Geber für ein Schaltgetriebe eines Kraftfahrzeugs mit einer Magnetfeldsensorvorrichtung mit mehreren Magneten und eine Erfassungseinrichtung zur Erfassung der Magnetfelder, die von den Magneten erzeugt werden um somit die Relativposition der Magneten zu bestimmen.

Die DE102007052146 offenbart eine Tastatur mit mindestens einer Taste, mit einem Magneten, mit mindestens einem magnetisch sensitiven Element, und mit einer Auswerteschaltung. Die Auswerteschaltung ist mit dem magnetisch sensitiven Element verbunden und das magnetisch sensitive Element ist dazu ausgestaltet, eine Veränderung der Lage der Taste kontaktlos zu detektieren.

Vor diesem Hintergrund schafft die vorliegende Erfindung eine verbesserte Tastenschaltvorrichtung für ein Fahrzeug sowie ein verbessertes Verfahren zur Bestimmung einer Relativposition zwischen einer ersten Komponente und einer zweiten Komponente gemäß den Hauptansprüchen. Vorteilhafte Ausgestaltungen ergeben sich aus den Unteransprüchen und der nachfolgenden Beschreibung.

Die vorliegende Erfindung betrifft eine Magnetfeldsensorvorrichtung mit einer zumindest zweiteiligen Gebereinrichtung mit mindestens zwei Magneten zur Erzeugung von zumindest zwei Magnetfeldern und einer Erfassungseinrichtung zur Erfassung der Magnetfelder, wobei die Magnete der Gebereinrichtung relativ zueinander und bezüglich der Erfassungseinrichtung beweglich angeordnet sind, wobei die Erfassungseinrichtung mindestens zwei Sensoren zum Erzeugen zumindest zweier von den Magnetfeldern abhängiger Sensorsignale aufweist, wobei die Sensoren benachbart zueinander in einem Erfassungsbereich in einem Überschneidungsbereich der Magnetfelder der mindestens zwei Magnete angeordnet sind.

Die Magnetfeldsensorvorrichtung weist somit die Gebereinrichtung und die Erfassungseinrichtung auf, die getrennt voneinander und relativ zueinander beweglich angeordnet sind. Die Gebereinrichtung kann mehrere Magnete bzw. Magnetelemente, jeweils in Form eines Dauermagneten oder eines Elektromagneten umfassen. Die Magnete können als Stabmagnete ausgeführt sein. Denkbar ist auch eine Verwendung einer Luft- oder Zylinderspule als Magnetelement. Jeder der Magnete kann ausgebildet sein, um ein Magnetfeld zu erzeugen. Somit kann jedes der Magnetfelder von einem der Magnete ausgehen. Weil die Gebereinrichtung zumindest zweiteilig ausgeführt ist, können die mindestens zwei Magnete relativ zueinander beweglich angeordnet sein. Jeder Teilabschnitt der Gebereinrichtung kann hierbei ausgebildet sein, um unabhängig von einem anderen Teilabschnitt der Gebervorrichtung eine Relativbewegung bezüglich der Erfassungseinrichtung zu vollführen. Die Erfassungseinrichtung kann mehrere Sensoren bzw. Sensorelemente aufweisen. Bei den Sensoren kann es sich um gebräuchliche Sensoren zur Messung der magnetischen Flussdichte handeln. Beispielsweise kann es sich bei den Sensoren um Hall-Sensoren, XMR-Sensoren (X-MagnetoResistive) oder Feldplatten handeln. Jeder der Sensoren kann ausgebildet sein, um ein von zumindest zwei Magnetfeldern abhängiges Sensorsignal zu erzeugen. Bei den Sensorsignalen kann es sich jeweils um ein elektrisches Signal, beispielsweise eine elektrische Spannung handeln. Dabei kann ein Sensorsignal kann eine Größe eines von dem das Sensorsignal erzeugenden Sensor erfassten Anteils von zumindest zwei Magnetfeldern repräsentieren. Somit kann eine Veränderung eines Magnetfeldes, die durch eine Positionsänderung bzw. Relativbewegung zwischen dem das Magnetfeld bewirkenden Magneten und dem das Sensorsignal erzeugenden Sensor bewirkt ist, zu einer durch die Veränderung des Magnetfeldes bewirkten Veränderung in dem Sensorsignal führen. Der Erfassungsbereich jedes der Sensoren kann hierbei in einem Überschneidungsbereich von zumindest zwei Magnetfeldern angeordnet sein, die durch zwei benachbarte Magnete bewirkt sind.

Eine Betätigungsvorrichtung für ein Fahrzeug weist folgende Merkmale auf:

eine zumindest zweiteilige erste Komponente;
eine zweite Komponente, wobei die erste Komponente und die zweite Komponente beweglich zueinander angeordnet sind; und
eine Ausführungsform der vorstehend genannten Magnetfeldsensorvorrichtung, wobei die Gebereinrichtung an der ersten Komponente und die Erfassungseinrichtung an der zweiten Komponente angeordnet ist.

Bei dem Fahrzeug kann es sich um ein Kraftfahrzeug, beispielsweise ein straßengebundenes Kraftfahrzeug, wie einen Personenkraftwagen oder einen Lastkraftwagen handeln. Bei der Betätigungsvorrichtung kann es sich um eine Tastenschaltvorrichtung zur Auswahl einer Fahrstufe bzw. Getriebestufe eines Kraftfahrzeuggetriebes, insbesondere eines automatischen Getriebes handeln. Die erste Komponente kann zumindest zwei Auswahltasten zum Auswählen von Fahrstufen bzw. Getriebestufen aufweisen. Hierbei kann jeweils ein Magnet der Gebereinrichtung der Magnetfeldsensorvorrichtung an einer Auswahltaste angeordnet sein. Bei der zweiten Komponente kann es sich um eine Aufnahmestruktur oder dergleichen für die Auswahltasten handeln. Es kann jeweils ein Sensor der Erfassungseinrichtung der Magnetfeldsensorvorrichtung in einem Aufnahmeabschnitt für eine Auswahltaste angeordnet sein. Wenn eine Auswahltaste gedrückt wird, erfolgt eine Relativbewegung zwischen Gebereinrichtung und Erfassungseinrichtung. Wenn keine Auswahltaste gedrückt ist, so sind die Magnete bzw. ist die Gebereinrichtung in einer Ausgangsposition bezüglich der Erfassungseinrichtung angeordnet. Wenn eine Auswahltaste gedrückt ist, so ist der eine Auswahltaste angeordnete Magnet in einer Betätigungsposition bezüglich der Erfassungseinrichtung angeordnet. Durch eine Auswertung der Sensorsignale der Magnetfeldsensorvorrichtung kann eine Relativposition zwischen den Komponenten bestimmt werden.

Ein Verfahren zur Bestimmung einer Relativposition zwischen einer zumindest zweiteiligen ersten Komponente und einer zweiten Komponente, die zueinander beweglich angeordnet sind, umfasst die folgenden Schritte:

Erzeugen von zumindest zwei Magnetfeldern mit einer an der ersten Komponente angeordneten, zumindest zweiteiligen Gebereinrichtung mit mindestens zwei Magneten zum Erzeugen der Magnetfelder;
Erfassen der Magnetfelder mit einer an der zweiten Komponente angeordneten Erfassungseinrichtung zur Erfassung der Magnetfelder, die mindestens zwei Sensoren zum Erzeugen zumindest zweier von den Magnetfeldern abhängiger Sensorsignale aufweist, wobei die Magnete der Gebereinrichtung relativ zueinander und bezüglich der Erfassungseinrichtung beweglich angeordnet sind, wobei die Sensoren benachbart zueinander in einem Erfassungsbereich in einem Überschneidungsbereich der Magnetfelder der mindestens zwei Magnete angeordnet sind; und
Kombinieren der Sensorsignale von der Erfassungseinrichtung, um die Relativposition zwischen der ersten Komponente und der zweiten Komponente zu bestimmen.

Das Verfahren kann in Verbindung mit einer Ausführungsform der vorstehend genannten Betätigungsvorrichtung vorteilhaft ausgeführt werden, um die Relativposition zwischen den Komponenten zu bestimmen.

Gemäß Ausführungsformen der vorliegenden Erfindung kann bei einer Magnetfeldsensorvorrichtung, die zur Positionserkennung eingesetzt werden kann, ein Magnetfeld von einer Gebereinrichtung erzeugt und von einer Erfassungseinrichtung erfasst werden, wobei insbesondere die Gebereinrichtung relativ zu der Erfassungseinrichtung beweglich angeordnet sein kann. Bewegen sich die Gebereinrichtung und die Erfassungseinrichtung relativ zueinander, so führt dies zu einer Veränderung der von der Erfassungseinrichtung erfassten Magnetfelder. Über eine Größe der von der Erfassungseinrichtung erfassten Magnetfelder kann auf die Relativposition zwischen der Gebereinrichtung und der Erfassungseinrichtung geschlossen werden. Die Magnetfeldsensorvorrichtung kann durch ein magnetisches Störfeld beeinflusst werden. Damit der Einfluss eines solchen Störfelds bei einer anschließenden Signalauswertung erkannt oder eliminiert werden kann, kann die Erfassungseinrichtung zumindest zwei Sensoren aufweisen. Die Sensoren können so ausgeführt und angeordnet sein, dass sie durch das Störfeld auf gleiche Art und Weise beeinflusst werden. Werden Sensorsignale der Sensoren auf geeignete Weise miteinander kombiniert, so kann ein in den Sensorsignalen enthaltener Anteil des Störfelds ermittelt oder eliminiert werden. Dies ermöglicht es, die Magnetfeldsensorvorrichtung auch in Anwendungsfällen einzusetzen, in denen mit einem sich ändernden Störfeld zu rechnen ist.

Insbesondere kann gemäß Ausführungsformen der vorliegenden Erfindung eine Störsignaleliminierung bei analogen Hallsensor-Systemen mit mehreren Gebereinheiten bzw. einer mehrteiligen Gebereinrichtung realisiert werden. So kann beispielsweise eine Störsignaleliminierung bei einer Tastenschaltvorrichtung ermöglicht werden, welche wenigstens zwei benachbarte, relativ zueinander bewegliche Auswahltasten zur Auswahl einer Getriebestufe eines Kraftfahrzeuggetriebes aufweist. Die Störsignaleliminierung wird über die Anordnung des jeder Auswahltaste zugeordneten Magnetelements und magnetfeldempfindlichen Sensorelements sowie der unterschiedlichen Polaritätsausrichtungen der zueinander benachbarten Magnetelemente realisiert.

Vorteilhafterweise kann mittels der Magnetfeldsensorvorrichtung somit eine Positionserfassung mit analogen Sensoren realisiert werden, die unempfindlich gegen äußere Störfelder ist. Da die Sensorik zumindest zweifach ausgelegt ist, kann verhindert werden, dass ein magnetisches Störfeld von außen die Positionserfassung der Sensorik verfälscht, insbesondere permanent oder elektrisch. Somit können Fehldiagnosen bzw. Fehlerfassungen zuverlässig vermieden werden. Mittels der Sensoren kann eine Positionserfassung sowie eine Plausibilisierung der erfassten Relativpositionen erzielt werden und zudem kann ein auf die Magnetfeldsensorvorrichtung wirkendes Störfeld ermittelt werden. Durch die Anordnung der Magnete lässt sich über mindestens zwei der Sensoren eine Erkennung von Störsignalen realisieren. Ferner können Mehrkosten oder aufwendige Änderungen vermieden werden, da bereits vorhandene Bauteile ausgenutzt werden. Zur Plausibilisierung einer erfassten Relativposition ist es vorteilhaft, dass sich eine die Relativposition beeinflussende Tastenbewegung sowohl auf den für die betätigte Taste vorgesehenen Sensor und als auch, in abgeschwächter Stärke und gegensätzlich gepolt, auf den Nachbarsensor auswirkt. Der Tastendruck wird somit mittels zumindest zweier Sensoren ermittelt. Dies verbessert die Störsicherheit und die Verfügbarkeit, ohne Mehrkosten zu verursachen.

Um Relativpositionen einer Anzahl n von Tasten zu delektieren, können n Taster, n Magneten, n Sensoren vorgesehen sein, wobei je ein Taster, ein Magnet und ein Sensor eine Einheit zur Positionserkennung repräsentieren.

Gemäß einer Ausführungsform der Magnetfeldsensorvorrichtung kann der Magnetfeldsensor eine Auswerteeinrichtung aufweisen, die ausgebildet ist, um die Sensorsignale von der Erfassungseinrichtung miteinander zu kombinieren, um eine den Magnetfeldern überlagerte magnetische Störgröße und zusätzlich oder alternativ einen Parameter der Magnetfelder und zusätzlich oder alternativ eine Relativposition zwischen der zumindest zweiteiligen Gebereinrichtung und der Erfassungseinrichtung zu bestimmen. Bei der Auswerteeinrichtung kann es sich um eine elektrische Schaltung handeln, die ausgebildet ist, um die Sensorsignale zu empfangen, auszuwerten und ein Auswertesignal bereitzustellen, dass die magnetische Störgröße, den Parameter der Magnetfelder bzw. die Relativposition repräsentiert. Zum Kombinieren der Sensorsignale oder durch die Sensorsignale repräsentierte Werte kann die Auswerteeinrichtung ausgebildet sein, um die Sensorsignale zu addieren oder zu subtrahieren oder einen Mittelwert aus den Sensorsignalen zu bilden. Eine Abmessung des Erfassungsbereichs, in dem die mindestens zwei Sensoren angeordnet sind, kann so gewählt sein, dass ein für einen Anwendungsbereich der Magnetfeldsensorvorrichtung zu erwartendes magnetisches Störfeld innerhalb des Erfassungsbereichs homogen oder annähernd homogen ist, sodass die Sensoren annähernd von dem gleichen magnetischen Störfeld beeinflusst werden. Somit kann zu gleichen Zeitpunkten jeweils ein in Stärke und Richtung annähernd gleiches magnetisches Störfeld auf die Sensoren einwirken. Annähernd gleich kann dabei beispielsweise innerhalb von Messtoleranzen der Magnetfeldsensorvorrichtung gleich bedeuten. Beispielsweise kann die Auswerteeinrichtung ausgebildet sein, um eine Größe und zusätzlich oder alternativ eine Richtung der magnetischen Störgröße innerhalb des Erfassungsbereichs zu bestimmen. Ferner kann die Auswerteeinrichtung ausgebildet sein, um eine Größe und zusätzlich oder alternativ eine Richtung der Magnetfelder innerhalb des Erfassungsbereichs zu bestimmen. Bei der Bestimmung der Größe und zusätzlich oder alternativ einer Richtung der Magnetfelder kann ein Einfluss der magnetischen Störgröße berücksichtigt und eliminiert oder reduziert werden. Ferner kann die Auswerteeinrichtung ausgebildet sein, um unter Verwendung von Referenzwerten sowie der Größe und zusätzlich oder alternativ der Richtung der Magnetfelder die Relativposition zwischen der Gebereinrichtung und der Erfassungseinrichtung zu bestimmen. Durch das Kombinieren der Sensorsignale kann ein Einfluss des magnetischen Störfelds auf die Sensorfunktion ermittelt und zusätzlich oder alternativ reduziert oder eliminiert werden.

Insbesondere kann die Gebereinrichtung einen ersten Teilabschnitt mit einem ersten Magneten zum Erzeugen eines ersten Magnetfelds und einen zweiten Teilabschnitt mit einem zweiten Magneten zum Erzeugen eines zweiten Magnetfelds aufweisen. Hierbei können der erste Teilabschnitt und der zweite Teilabschnitt der Gebereinrichtung relativ zueinander beweglich angeordnet sein. Der erste Magnet kann identisch zu dem zweiten Magneten ausgeführt sein. Der erste Magnet und der zweite Magnet können als Stabmagnete ausgeführt sein. Eine Längsachse eines Magneten kann jeweils durch eine Achse zwischen dem magnetischen Nordpol und dem magnetischen Südpol des Magneten definiert werden. Eine erste Längsachse des ersten Magnets kann parallel zu einer zweiten Längsachse des zweiten Magnets ausgerichtet sein. Die erste Längsachse kann in allen vorgesehenen möglichen Relativpositionen zwischen der Gebereinrichtung und der Erfassungseinrichtung durch den ersten Sensor gerichtet sein. Die zweite Längsachse kann in allen vorgesehenen möglichen Relativpositionen zwischen der Gebereinrichtung und der Erfassungseinrichtung durch den zweiten Sensor gerichtet sein. Die erste Längsachse und die zweite Längsachse können in den vorgesehenen möglichen Relativpositionen jeweils parallel zueinander angeordnet sein. Gemäß dieser Ausführungsform kann die Gebereinrichtung durch zwei Magnete realisiert sein. Das erste Magnetfeld kann zwischen dem magnetischen Nordpol und dem magnetischen Südpol des ersten Magneten verlaufen. Das zweite Magnetfeld kann zwischen dem magnetischen Nordpol und dem magnetischen Südpol des zweiten Magneten verlaufen.

Dabei können der erste Magnet und der zweite Magnet mit relativ zueinander entgegengesetzter Polausrichtung angeordnet sein. Auch können hierbei das erste Magnetfeld und das zweite Magnetfeld in entgegengesetzter Richtung zueinander ausgerichtet sein. Anders ausgedrückt weisen benachbart angeordnete Magneten eine relativ zueinander unterschiedliche Polausrichtung bezüglich der Erfassungseinrichtung auf. Beispielsweise kann der magnetische Nordpol des ersten Magneten einem ersten Sensor zugewandt bzw. gegenüberliegend angeordnet sein und kann der magnetische Südpol des zweiten Magneten einem zweiten Sensor zugewandt bzw. gegenüberliegend angeordnet sein. Indem das erste Magnetfeld und das zweite Magnetfeld in entgegengesetzter Richtung zueinander ausgerichtet sein können, kann eine potenzielle magnetische Störgröße bei einem der Sensoren zu einer Verstärkung des erfassten Magnetfelds und bei dem anderen der Sensoren zu einer Verringerung des erfassten Magnetfelds führen. Somit kann eine Erfassung und Plausibilisierung einer Relativposition der Gebereinrichtung bezüglich der Erfassungseinrichtung zuverlässiger und unaufwendiger erfolgen.

Ferner kann die Erfassungseinrichtung einen ersten Sensor und einen zweiten Sensor aufweisen. Dabei kann der erste Sensor ausgebildet sein, um ein erstes Sensorsignal abhängig von dem ersten Magnetfeld und dem zweiten Magnetfeld zu erzeugen. Der zweite Sensor kann ausgebildet sein, um ein zweites Sensorsignal abhängig von dem ersten Magnetfeld und dem zweiten Magnetfeld zu erzeugen. Hierbei kann eine Sensierrichtung des ersten Sensors einer Sensierrichtung des zweiten Sensors entsprechen. Der erste Sensor und der zweite Sensor können identisch ausgeführt sein. Der erste und der zweite Sensor können einander entsprechend ausgerichtet und verschaltet oder elektrisch kontaktiert sein. Dabei kann eine Sensierrichtung oder Sensiercharakteristik des ersten Sensors einer Sensierrichtung oder Sensiercharakteristik des zweiten Sensors entsprechen. Dies bedeutet, dass ein gedachtes Magnetfeld beliebiger Art bei einer Einwirkung auf den ersten Sensor das gleiche Sensorsignal hervorruft, wie bei einer Einwirkung auf den zweiten Sensor. Beispielsweise können Grundflächen oder Kontaktierungsflächen der Sensoren gleich ausgerichtet sein. Der erste Sensor kann beispielsweise gegenüberliegend zu oder in einem Haupteinflussbereich des magnetischen Nordpols des ersten Magneten angeordnet sein. Der zweite Sensor kann beispielsweise gegenüberliegend zu oder in einem Haupteinflussbereich eines magnetischen Südpols des zweiten Magneten angeordnet sein. Gemäß dieser Ausführungsform werden zwei Magnetfelder erzeugt, wobei das erste Magnetfeld von dem ersten Sensor sowie dem zweiten Sensor erfasst wird und das zweite Magnetfeld von dem zweiten Sensor sowie dem ersten Sensor erfasst wird. Pro Magnetfeld können zwei Sensoren, bei anderen Ausführungsformen auch mehr als zwei Sensoren, zur Erfassung vorgesehen sein. Somit kann die Erfassung und Plausibilisierung der Magnetfeldparameter bzw. der Relativposition der Gebereinrichtung bezüglich der Erfassungseinrichtung exakter und zuverlässiger erfolgen.

Dabei können im Betrieb der Magnetfeldsensorvorrichtung eine Magnetfeldlinie des ersten Magnetfeldes und eine Magnetfeldlinie des zweiten Magnetfeldes sowohl den ersten Sensor als auch den zweiten Sensor durchdringen. Im Betrieb des Magnetfeldsensors kann eine Magnetfeldlinie eines gewählten Magnetfelds den ersten Sensor in einem ersten Winkel bezüglich einer Sensierebene des ersten Sensors durchdringen und kann eine Magnetfeldlinie des gewählten Magnetfelds den zweiten Sensor in einem von dem ersten Winkel unterschiedlichen, zweiten Winkel bezüglich einer Sensierebene des zweiten Sensors durchdringen. Somit kann aufgrund der Doppelerfassung erreicht werden, dass Magnetfelderfassung sowie Messwertplausibilisierung unempfindlicher gegenüber Störungen und genauer sind.

Gemäß einer Ausführungsform können die Magnetfelder betragsmäßig gleich groß sein. Dies kann insbesondere für den Erfassungsbereich gelten. Gleich große Magnetfelder können realisiert werden, indem identische Magnete eingesetzt werden. Wenn ein erstes Magnetfeld entgegengesetzt zu einem zweiten Magnetfeld ausgerichtet ist, können das erste Sensorsignal und das zweite Sensorsignal oder durch das erste und das zweite Sensorsignal repräsentierte Werte bei Abwesenheit eines magnetischen Störfelds unterschiedliche Vorzeichen, jedoch den gleichen Betrag aufweisen. Aufgrund der betragsmäßig gleich großen Magnetfelder lässt sich ein magnetisches Störfeld besonders einfach aus den Sensorsignalen bestimmen.

Auch können die Sensoren nebeneinander in einer Sensierebene und zusätzlich oder alternativ an einem gemeinsamen Trägersubstrat angeordnet sein. Die Sensierebene kann beispielsweise durch eine Oberfläche einer Leiterplatte bzw. Platine oder eines anderen Trägersubstrates gebildet sein. Das Trägersubstrat bzw. die Leiterplatte kann elektrische Leitungen zur Kontaktierung der Sensoren aufweisen. Die Sensoren können an einem gemeinsamen Trägersubstrat oder an getrennten Trägersubstraten angeordnet sein. Unter Sensierebene kann eine Fläche verstanden werden, die von einem durch einen Sensor zu erfassenden oder zu sensierenden Magnetfeld durchdrungen wird. Hierbei können die Sensoren in einer gemeinsamen Sensierebene oder in relativ zueinander schrägen Sensierebenen angeordnet sein.

Die Sensoren können weitere Sensierebenen aufweisen, die orthogonal zu der bereits genannten Sensierebene ausgerichtet sein können. Ein zweidimensionaler Sensor kann zwei Sensierebenen und ein dreidimensionaler Sensor drei Sensierebenen aufweisen, die jeweils orthogonal zueinander ausgerichtet sind. Die Sensoren können somit als eindimensionale, zweidimensionale oder dreidimensionale Sensoren ausgeführt sein.

Die Erfindung wird anhand der beigefügten Zeichnungen beispielhaft näher erläutert. Es zeigen:

| | |
|---|---|
| Fig. 1 | eine schematische Darstellung einer Betätigungsvorrichtung gemäß einem Ausführungsbeispiel der vorliegenden Erfindung; |
| Fig. 2 | ein Ablaufdiagramm eines Verfahrens zur Bestimmung einer Relativposition gemäß einem Ausführungsbeispiel der vorliegenden Erfindung; und |
| Figuren 3A und 3B | schematische Darstellungen eines Teils einer Magnetfeldsensorvorrichtung gemäß einem Ausführungsbeispiel der vorliegenden Erfindung in unterschiedlichen Relativpositionen. |

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

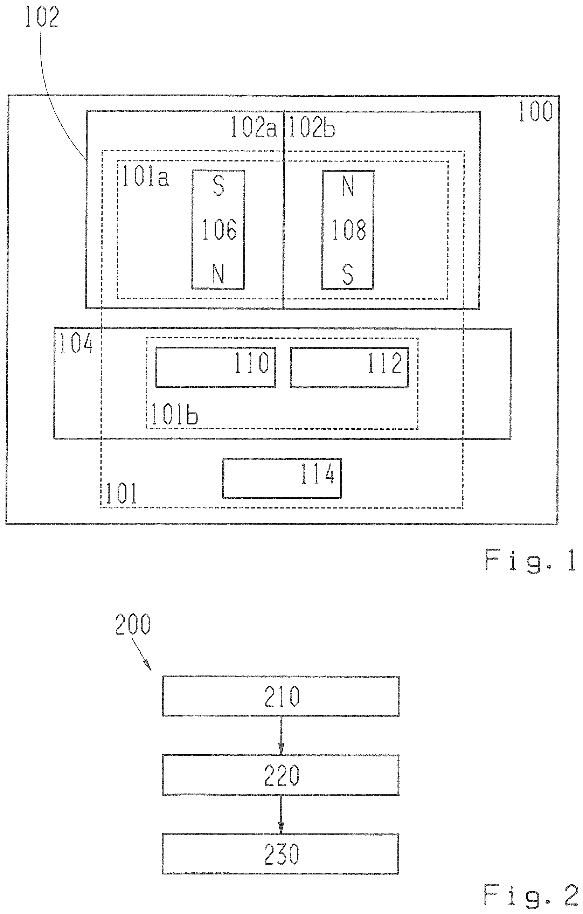

Fig. 1 zeigt eine schematische Darstellung einer Betätigungsvorrichtung 100 für ein Fahrzeug, gemäß einem Ausführungsbeispiel der vorliegenden Erfindung. Gezeigt sind die Betätigungsvorrichtung 100, eine Magnetfeldsensorvorrichtung 101, eine Gebereinrichtung 101a, eine Erfassungseinrichtung 101b, eine erste Komponente 102, ein erster Teilabschnitt 102a, ein zweiter Teilabschnitt 102b, eine zweite Komponente 104, ein erster Magnet 106, ein zweiter Magnet 108, ein erster Sensor 110, ein zweiter Sensor 112 und eine Auswerteeinrichtung 114. Beispielsweise handelt es sich bei der Betätigungsvorrichtung 100 um eine Vorrichtung zur Auswahl einer Getriebestufe eines Getriebes eines Fahrzeugs.

Die Betätigungsvorrichtung 100 weist die Magnetfeldsensorvorrichtung 101, die erste Komponente 102 und die zweite Komponente 104 auf. Die erste Komponente 102 weist einen ersten Teilabschnitt 102a und einen zweiten Teilabschnitt 102b auf. Der erste Teilabschnitt 102a und der zweite Teilabschnitt 102b sind relativ zueinander bewegbar. Gemäß dem in Fig. 1 gezeigten Ausführungsbeispiel der vorliegenden Erfindung sind dabei der erste Teilabschnitt 102a und der zweite Teilabschnitt 102b der ersten Komponente 102 aneinander angrenzend angeordnet. Gemäß einem anderen Ausführungsbeispiel sind die Teilabschnitte 102a und 102b voneinander beabstandet angeordnet. Der erste Teilabschnitt 102a und der zweite Teilabschnitt 102b der ersten Komponente 102 repräsentieren beispielsweise einzelne Tasten einer Tastenschaltvorrichtung zur Auswahl einer Getriebestufe eines Kraftfahrzeugs. Die zweite Komponente 104 ist getrennt von der ersten Komponente 102 angeordnet. Beispielsweise ist die zweite Komponente 104 als eine Aufnahmevorrichtung oder Führungsvorrichtung für die erste Komponente 102 ausgebildet. Die erste Komponente 102 ist beispielsweise relativ zu der zweiten Komponente 104 bewegbar, insbesondere entlang einer Bewegungsachse zu der zweiten Komponente 104 hin und von der zweiten Komponente 104 weg. Dabei sind der erste Teilabschnitt 102a und der zweite Teilabschnitt 102b der ersten Komponente 102 unabhängig voneinander relativ zu der zweiten Komponente 104 bewegbar.

Die Magnetfeldsensorvorrichtung 101 weist die Gebereinrichtung 101a und die Erfassungseinrichtung 101b sowie die Auswerteeinrichtung 114 auf. Die Gebereinrichtung 101a ist an der ersten Komponente 102 angeordnet. Die Erfassungseinrichtung 101b ist an der zweiten Komponente 104 angeordnet. Die Auswerteeinrichtung 114 ist gemäß dem in Fig. 1 dargestellten Ausführungsbeispiel der vorliegenden Erfindung getrennt von der ersten Komponente 102 und der zweiten Komponente 104 angeordnet. Gemäß einem anderen Ausführungsbeispiel ist die Auswerteeinrichtung 114 mit der Erfassungseinrichtung 101b integriert oder dergleichen.

Die Gebereinrichtung 101a weist gemäß dem in Fig. 1 gezeigten Ausführungsbeispiel einen ersten Magneten 106 mit einem magnetischen Nordpol N und einem magnetischen Südpol S sowie einen zweiten Magneten 108 mit einem magnetischen Nordpol N und einem magnetischen Südpol S auf. Bei den Magneten 106 und 108 handelt es sich beispielsweise um Stabmagnete. Der erste Magnet 106 ist an dem ersten Teilabschnitt 102a der ersten Komponente 102 angeordnet. Dabei ist gemäß diesem Ausführungsbeispiel der magnetische Nordpol N des ersten Magneten 106 der zweiten Komponente 104 bzw. der Erfassungseinrichtung 101b zugewandt angeordnet. Der zweite Magnet 108 ist an dem zweiten Teilabschnitt 102b der ersten Komponente 102 angeordnet. Dabei ist gemäß diesem Ausführungsbeispiel der magnetische Südpol S des zweiten Magneten 108 der zweiten Komponente 104 bzw. der Erfassungseinrichtung 101b zugewandt angeordnet. Somit ist die Erfassungseinrichtung 101a zweiteilig ausgeführt.

Die Erfassungseinrichtung 101b weist gemäß diesem Ausführungsbeispiel den ersten Sensor 110 und den zweiten Sensor 112 auf. Der erste Sensor 110 ist in einem dem ersten Teilabschnitt 102a gegenüberliegenden Bereich der zweiten Komponente 104 angeordnet. Insbesondere ist der erste Sensor 110 in einem dem magnetischen Nordpol N des ersten Sensors 106 gegenüberliegenden Bereich der zweiten Komponente 104 angeordnet. Der zweite Sensor 112 ist in einem dem zweiten Teilabschnitt 102b gegenüberliegenden Bereich der zweiten Komponente 104 angeordnet. Insbesondere ist der zweite Sensor 112 in einem dem magnetischen Südpol S des zweiten Sensors 108 gegenüberliegenden Bereich der zweiten Komponente 104 angeordnet.

Der erste Magnet 106 ist ausgebildet, um ein erstes Magnetfeld zu erzeugen bzw. bewirken. Der zweite Magnet 108. ausgebildet, um ein zweites Magnetfeld zu erzeugen bzw. zu bewirken. Der erste Sensor 110 ist ausgebildet, um ein erstes Sensorsignal zu erzeugen und bereitzustellen, wobei das erste Sensorsignal ein von dem ersten Sensor 110 erfasstes Magnetfeld repräsentiert, das sich aus einer Überlagerung des ersten Magnetfeldes des ersten Magneten 106, des zweiten Magnetfeldes des zweiten Magneten 108 und einem eventuell vorhandenen magnetischen Störfeld zusammensetzt. Der zweite Sensor 112 ist ausgebildet, um ein zweites Sensorsignal zu erzeugen und bereitzustellen, wobei das zweite Sensorsignal ein von dem zweiten Sensor 112 erfasstes Magnetfeld repräsentiert, das sich aus einer Überlagerung des zweiten Magnetfeldes des zweiten Magneten 108, des ersten Magnetfeldes des ersten Magneten 106 und einem eventuell vorhandenen magnetischen Störfeld zusammensetzt.

Die Auswerteeinrichtung 114 ist ausgebildet, um das erste Sensorsignal des ersten Sensors 110 und das zweite Sensorsignal des zweiten Sensors 112 einzulesen und auszuwerten. Dazu kann die Auswerteeinrichtung 114 mittels einer Kommunikationsschnittstelle, beispielsweise drahtlos oder über elektrische Leitungen mit den Sensoren 110, 112 verbunden sein. Die Auswerteeinrichtung 114 ist ausgebildet, um das erste Sensorsignal mit dem zweiten Sensorsignal zu kombinieren, um eine Relativposition zwischen der Gebereinrichtung 101a und der Erfassungseinrichtung 101b und damit eine Relativposition zwischen der ersten Komponente 102 und der zweiten Komponente 104 bzw. zwischen jedem Teilabschnitt 102a und 102b und der zweiten Komponente 104 zu bestimmen. Dabei ist die Auswerteeinrichtung 114 ausgebildet, um die Relativposition anhand zumindest eines Parameters der Magnetfelder unabhängig von einer Größe und Richtung des eventuell vorhandenen magnetischen Störfelds zu bestimmen. Dabei kann die Auswerteeinrichtung 114 ausgebildet sein, um einen Anteil des magnetischen Störfelds zunächst zu bestimmen und anschließend bei der Bestimmung der Relativposition zu berücksichtigen. Alternativ kann die Auswerteeinrichtung 114 ausgebildet sein, um die Relativposition direkt zu bestimmen, wobei der Anteil des magnetischen Störfelds bei der Bestimmung der Relativposition durch eine geeignete Kombination des ersten Sensorsignals und des zweiten Sensorsignals eliminiert wird.

Fig. 2 zeigt ein Ablaufdiagramm eines Verfahrens 200 zur Bestimmung einer Relativposition, gemäß einem Ausführungsbeispiel der vorliegenden Erfindung. Mittels des Verfahrens 200 ist eine Relativposition zwischen einer zumindest zweiteiligen ersten Komponente und einer zweiten Komponente bestimmbar, die zueinander beweglich angeordnet sind. So ist mittels des Verfahrens 200 beispielsweise eine Relativposition zwischen den in Fig. 1 gezeigten Komponenten einer Betätigungsvorrichtung bestimmbar.

In einem Schritt 210 werden zumindest zwei Magnetfelder mittels einer an der ersten Komponente angeordneten, zumindest zweiteiligen Gebereinrichtung mit mindestens zwei Magneten erzeugt. Die Magnetfelder können permanent oder über einen begrenzten Zeitraum, beispielsweise während eines Messzyklus erzeugt werden.

In einem Schritt 220 werden die Magnetfelder mittels einer an der zweiten Komponente angeordneten Erfassungseinrichtung erfasst. Die Erfassungseinrichtung weist mindestens zwei Sensoren zum Erzeugen zumindest zweier von den Magnetfeldern abhängiger Sensorsignale auf. Dabei sind die Magnete der Gebereinrichtung relativ zueinander und bezüglich der Erfassungseinrichtung beweglich angeordnet. Hierbei sind die Sensoren benachbart zueinander in einem Überschneidungsbereich der Magnetfelder der mindestens zwei Magneten befindlichen Erfassungsbereich angeordnet.

In einem Schritt 230 werden die Sensorsignale von der Erfassungseinrichtung in geeigneter Weise miteinander kombiniert, um die Relativposition zwischen der ersten Komponente und der zweiten Komponente zu bestimmen.

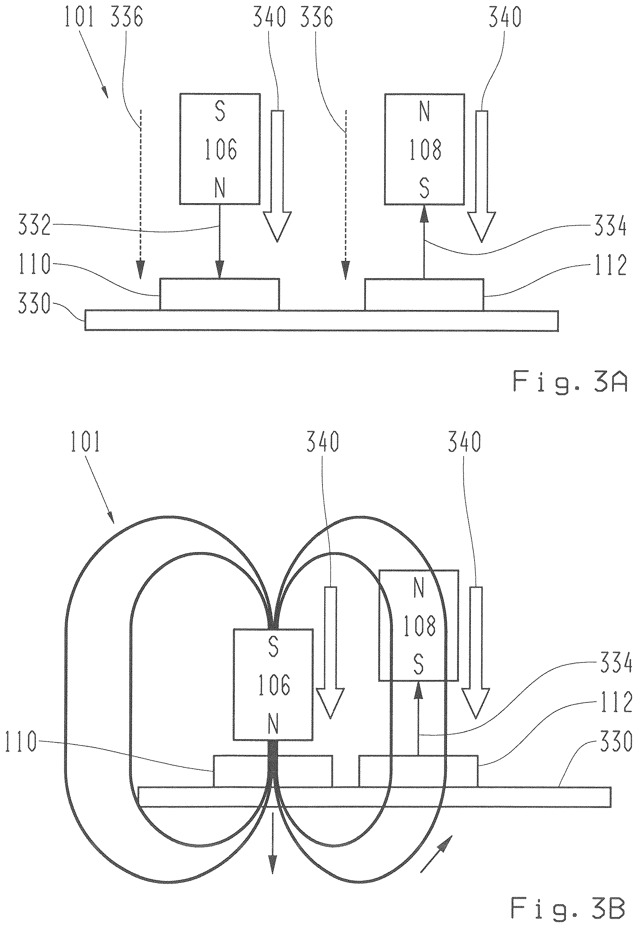

Fig. 3A zeigt eine schematische Darstellung eines Teils einer Magnetfeldsensorvorrichtung 101 gemäß einem Ausführungsbeispiel der vorliegenden Erfindung. Die Magnetfeldsensorvorrichtung 101 entspricht oder ähnelt der in Fig. 1 gezeigten und beschriebenen Magnetfeldsensorvorrichtung. Die Magnetfeldsensorvorrichtung 101 ist hierbei Teil einer Betätigungsvorrichtung, wie der in Fig. 1 gezeigten und beschriebenen Betätigungsvorrichtung. Gezeigt sind von der Magnetfeldsensorvorrichtung 101 ein erster Magnet 106, ein zweiter Magnet 108, ein erster Sensor 110 und ein zweiter Sensor 112. Ferner gezeigt sind ein Träger 330, ein erstes Magnetfeld 332, ein zweites Magnetfeld 334, ein magnetisches Störfeld 336 und eine Relativbewegung 340. In Fig. 3A ist die Magnetfeldsensorvorrichtung 101 mit den Magneten 106 und 108 in einer ersten Relativposition bezüglich der Sensoren 110 und 112 dargestellt. Die erste Relativposition entspricht hierbei einem unbetätigten Zustand der Betätigungsvorrichtung, welche die Magnetfeldsensorvorrichtung 101 aufweist.

Die Sensoren 110 und 112 sind an dem Träger 330 angeordnet. Bei dem Träger 330 handelt es sich beispielsweise um eine Schaltungsplatine oder dergleichen. Die Sensoren 110 und 112 sind nebeneinander und lateral voneinander beabstandet an dem Träger 330 angeordnet. Der erste Magnet 106 ist dem ersten Sensor 110 gegenüberliegend angeordnet. Ein Pol des ersten Magneten 106, hier der Nordpol, ist gegenüber einer Sensierfläche des ersten Sensors 110 ausgerichtet. Der erste Magnet 106 ist ausgebildet, um das erste Magnetfeld 332 zu erzeugen, das von dem ersten Sensor 110 und dem zweiten Sensor 112 erfassbar ist. Der zweite Magnet 108 ist dem zweiten Sensor 112 gegenüberliegend angeordnet. Ein Pol des zweiten Magneten 108, hier der Südpol, ist gegenüber einer Sensierfläche des zweiten Sensors 112 ausgerichtet. Der zweite Magnet 108 ist ausgebildet, um ein zweites Magnetfeld 334 zu erzeugen, das von dem zweiten Sensor 112 und dem ersten Sensor 110 erfassbar ist.

Das von dem ersten Sensor 110 erfasste Magnetfeld ist abhängig von einer Stellung des ersten Magneten 106 und des zweiten Magneten 108 in Bezug zu dem ersten Sensor 110. Somit ist das von dem ersten Sensor 110 erzeugte, erste Sensorsignal abhängig von dem ersten Magnetfeld 332 und dem zweiten Magnetfeld 334. Das von dem zweiten Sensor 112 erfasste Magnetfeld ist abhängig von einer Stellung des zweiten Magneten 108 und des ersten Magneten 106 in Bezug zu dem zweiten Sensor 112. Somit ist das von dem zweiten Sensor 112 erzeugte, zweite Sensorsignal abhängig von dem zweiten Magnetfeld 334 und dem ersten Magnetfeld 332.

Die Sensoren 110 und 112 sind in einem Erfassungsbereich angeordnet, der von dem magnetischen Störfeld 336 beeinflusst sein kann. Der Erfassungsbereich kann so klein gewählt sein, dass das magnetische Störfeld 336 innerhalb des Erfassungsbereichs nahezu homogen ist, die Sensoren 110 und 112 also einem magnetischen Störfeld 336 mit im Wesentlichen gleichen Charakteristika beeinflusst werden. Ein Vorhandensein und eine Größe des magnetischen Störfelds 336 können dabei unbekannt sein. Das erste Magnetfeld 332 und das zweite Magnetfeld 334 sind jeweils in Richtungsvektoren [Sx] und das magnetische Störfeld 336 ist in Richtungsvektoren [St] gezeigt. Das erste Magnetfeld 332 wird von dem magnetischen Störfeld 336 überlagert. Das zweite Magnetfeld 334 wird ebenfalls von dem magnetischen Störfeld 336 überlagert. Aufgrund der unterschiedlichen Polausrichtung der Magnete 106 und 108 bezüglich der Sensoren 110 und 112 ist das erste Magnetfeld 332 entgegengesetzt zu dem zweiten Magnetfeld 334 ausgerichtet. Die Magnetfelder 332, 334 sind beispielsweise betragsmäßig gleich groß.

In der ersten Relativposition ist der erste Magnet 106 um einen ersten Abstand von dem ersten Sensor 110 beabstandet und ist der zweite Magnet 108 um einen zweiten Abstand von dem zweiten Sensor 112 beabstandet, wobei der erste Abstand innerhalb von Messtoleranzen gleich dem zweiten Abstand ist. Ausgehend von der in Fig. 3A gezeigten ersten Relativposition können der erste Magnet 106 und der zweite Magnet 108 einzeln bzw. unabhängig voneinander in die mittels eines Richtungspfeils in Fig. 3A veranschaulichte Relativbewegung 340 bezüglich der Sensoren 110 und 112 versetzt werden. Dabei können der erste Magnet 106 und der zweite Magnet 108 jeweilige zweite Relativpositionen bezüglich der Sensoren 110 und 112 erreichen. Aus den mittels der Sensoren 110 und 112 erfassten Magnetfeldern kann auf eine Relativposition der Magnete 106 und 108 bezüglich der Sensoren 110 und 112 geschlossen werden.

Fig. 3B zeigt die Magnetfeldsensorvorrichtung 101 aus Fig. 3A mit dem ersten Magneten 106 in der zweiten Relativposition und dem zweiten Magneten 108 in der ersten Relativposition bezüglich der Sensoren 110 und 112. Somit ist der erste Magnet 106 näher an dem ersten Sensor 110 angeordnet als der zweite Magnet 108 an dem zweiten Sensor 112. Abgesehen von der zu Fig. 3A unterschiedlichen Relativposition entspricht hierbei die Darstellung in Fig. 3B jener aus Fig. 3A mit der Ausnahme, dass in Fig. 3B Magnetfeldlinien des ersten Magnetfeldes des ersten Magneten 106 mit entsprechenden Richtungspfeilen zur Veranschaulichung eingezeichnet sind und das Störfeld nicht dargestellt ist. Es ist zu erkennen, dass die Magnetfeldlinien des ersten Magnetfeldes des ersten Magneten 106 den ersten Sensor 110 und den zweiten Sensor 112 durchdringen. Dabei durchdringen die Magnetfeldlinien des ersten Magnetfeldes des ersten Magneten 106 den ersten Sensor 110 in einem ersten Winkel und den zweiten Sensor 112 in einem von dem ersten Winkel unterschiedlichen, zweiten Winkel.

Im Folgenden wird anhand der Figuren 1 bis 3B ein Ausführungsbeispiel zur Störsignaleliminierung bei einem analogen Hallsensor-System beschrieben, bei dem es sich um die Magnetfeldsensorvorrichtung 101 handeln kann. Entsprechend kann es sich bei den Sensoren 110, 112 um Hall-Sensoren handeln. Ein solches Sensorsystem ist störempfindlich für äußere Einflüsse von Fremdmagnetfeldern bzw. Störfeldern 336, die permanenter oder elektrischer Natur sein können. Das Sensorsystem bzw. die Magnetfeldsensorvorrichtung 101 umfasst mindestens zwei Magnete 106 und 108 sowie mindestens zwei analoge Sensoren 110 und 112. Die Auslegung des Systems ist so gewählt, dass beide Sensoren 110, 112 zur Positionserkennung genutzt werden und die Größe und Richtung relevanter Störfelder 336 erfassen können. Somit lässt sich mittels einer Korrekturrechnung die Störgröße 336 eliminieren. Eine entsprechende Korrekturrechnung kann beispielsweise in der in Fig. 1 gezeigten Auswerteeinrichtung 114 durchgeführt werden.

Gemäß einem Ausführungsbeispiel erfolgt eine Ermittlung des Störgrößenvektors des Störfelds 336 gemäß folgender Formel:

$$\left( \frac{\vec{S}_1 + \vec{S}_2}{2} \right) = \vec{S}_t$$

$\vec{S}_t$ :    Störgrößenvektor des Störfelds 336
$\vec{S}_1$ :    Vektor des von dem ersten Sensor 110 sensierten Magnetfelds
$\vec{S}_2$ :    Vektor des von dem zweiten Sensor 112 sensierten Magnetfelds

Entsprechend erfolgt die Ermittlung der Position mit Redundanzabgleich und bzw. Plausibilisierung gemäß folgender Formel:

$$\vec{S}_1 - \vec{S}_t == \vec{S}_2 - \vec{S}_t$$

Das zugrunde liegende Funktionsprinzip wird im Folgenden beschrieben.

Zwei gleiche Sensoren 110 und 112 bzw. Hall-Sensoren werden zu zwei entgegengesetzt gepolten Magneten 106 und 108 positioniert, bei denen es sich um permanente oder elektrische Magnete handeln kann. Die Magnete 106 und 108 sind unabhängig voneinander bezüglich der Sensoren 110 und 112 bewegbar. Durch die gegenläufige Ausrichtung der Magnetfelder 332 und 334 lässt sich durch Abzug der beiden mit den Sensoren 110 und 112 sensierten Felder das Störfeld 336 ermitteln. Durch Abzug des Störfeldes 336 vom sensierten Magnetfeld [S1] des ersten Sensors 110 sowie vom sensierten Magnetfeld [S2] des zweiten Sensors 112 lässt sich die Relativposition ermitteln. Anschließend wird die relative Position über die beiden bereinigten sensierten Werte plausibilisiert. Somit dienen hierbei die beiden Sensoren 110 und 112 der Positionserfassung sowie der Plausibilisierung und werden auch genutzt, um das Störfeld 336 zu ermitteln und die Positionserfassung unter Berücksichtigung des Störfelds 336 zu bereinigen.

Im Folgenden wird unter Bezugnahme auf die Figuren 1 bis 3B ein Ausführungsbeispiel eines Tastenschalters zum Auswählen von Getriebestufen eines Kraftfahrzeugs beschrieben. Der Tastenschalter umfasst lediglich beispielhaft vier Tasten, die jeweils über ein separates Sensorsystem bestehend aus einem Magneten und einem analogen Sensor verfügen. Beim Betätigen einer Taste wird der Magnet dichter zum Sensor bewegt, wobei das Magnetfeld im Sensor stärker wird. Eine unbestätigte Taste wirkt mit einem schwachen Magnetfeld auf den Sensor.

Es sind beispielsweise jeweils zwei benachbarte Tasten zu einem Tastenpaar zusammengefasst, z. B. P/R für Parkstellung und Rückwärtsfahrt oder N/D für Neutral- bzw. Leerlaufstellung und Vorwärtsfahrt, und die Sensorpositionen eines Tastenpaares möglichst dicht nebeneinander konstruiert. Jedes der Tastenpaare repräsentiert hierbei eine Betätigungsvorrichtung 100, wie sie in Fig. 1 dargestellt ist, und umfasst eine Magnetfeldsensorvorrichtung 101 aus den Figuren 1, 3A und 3B. Dabei stellen die Tasten eines Paares die erste Komponente 102 der Betätigungsvorrichtung 100 dar.

Die beiden Permanentmagneten 106 und 108 innerhalb eines Tastenpaares sind gegenläufig angeordnet, d. h. beispielsweise hat eine Taste P den ersten Magneten 106 mit dem N-Pol dem ersten Sensor 110 zugewandt und hat eine Taste R den zweiten Magneten 108 mit dem S-Pol dem zweiten Sensor 112 zugewandt. Zur Ermittlung eines Störfeldes 336 werden die Sensorergebnisse von einem Tastenpaar zusammengerechnet. Das Nutzsignal löscht sich heraus und der Störanteil bleibt über. Somit kann aus den Sensorsignalen der Sensoren 110 und 112 der Nutzanteil ermittelt werden. Eine Plausibilisierung kann über die Paare ausgeweitet und verbessert werden, d. h. es wird, wie oben beschrieben, ein Störsignal für das Paar P/R ($S_{PR}$) ermittelt und ein weiteres für das Paar N/D ($S_{ND}$). Die beiden Störsignale $S_{PR}$ und $S_{ND}$ können verglichen und plausibilisiert werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden.

Umfasst ein Ausführungsbeispiel eine "und/oder" Verknüpfung zwischen einem ersten Merkmal und einem zweiten Merkmal, so kann dies so gelesen werden, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

Bezugszeichen

| | |
|---|---|
| 100 | Betätigungsvorrichtung |
| 101 | Magnetfeldsensorvorrichtung |
| 101a | Gebereinrichtung |
| 101b | Erfassungseinrichtung |
| 102 | erste Komponente |
| 102a | erster Teilabschnitt |
| 102b | zweiter Teilabschnitt |
| 104 | zweite Komponente |
| 106 | erster Magnet |
| 108 | zweiter Magnet |
| 110 | erster Sensor |
| 112 | zweiter Sensor |
| 114 | Auswerteeinrichtung |
| 200 | Verfahren zur Bestimmung einer Relativposition |
| 210 | Schritt des Erzeugens |
| 220 | Schritt des Erfassens |
| 230 | Schritt des Kombinierens |
| 330 | Träger |
| 332 | erstes Magnetfeld |
| 334 | zweites Magnetfeld |
| 336 | magnetisches Störfeld |
| 340 | Relativbewegung |

**Patentansprüche**

1. Tastenschaltvorrichtung (100) für ein Fahrzeug, umfassend eine erste Komponente (102) mit zumindest zwei betätigbaren Auswahltasten zum Auswählen von Fahrstufen;
eine zweite Komponente (104) zur Aufnahme der Auswahltasten, wobei die Auswahltasten beweglich zu der zweiten Komponente (104) sind; und
eine Magnetfeldsensorvorrichtung (101) mit
mindestens zwei Magneten (106, 108) zur Erzeugung von zumindest zwei Magnetfeldern (332, 334), wobei die zumindest zwei Magneten (106, 108) einer zumindest zweiteiligen Gebereinrichtung (101a) zugeordnet sind und jeweils ein Magnet (106, 108) an einer Auswahltaste angeordnet ist, und

mindestens zwei Sensoren (110, 112) zum Erzeugen zumindest zweier von den Magnetfeldern (332, 334) abhängiger Sensorsignale, wobei die zumindest zwei Sensoren (110, 112) einer Erfassungseinrichtung (101b) zugeordnet sind, welche an der zweiten Komponente (104) angeordnet ist, und wobei die Sensoren (110, 112) derart benachbart zueinander angeordnet sind, dass ein Erfassungsbereich jedes Sensors (110, 112) in einem Überschneidungsbereich von zumindest zwei Magnetfeldern (332, 334), die durch zwei benachbarte Magnete (106, 108) der zumindest zwei Magneten (106, 108) bewirkt sind, angeordnet ist, wobei die Tastenschaltvorrichtung (100) eine Auswerteeinrichtung (114) aufweist, die ausgebildet ist, um die Sensorsignale von der Erfassungseinrichtung (101b) miteinander zu kombinieren, um eine den Magnetfeldern (332, 334) überlagerte magnetische Störgröße (336) zu bestimmen.

2. Tastenschaltvorrichtung (100) gemäß Anspruch 1, **dadurch gekennzeichnet, dass** die Magnetfeldsensorvorrichtung (101) eine Auswerteeinrichtung (114) aufweist, die ausgebildet ist, um die Sensorsignale von der Erfassungseinrichtung (101b) miteinander zu kombinieren, um einen Parameter der Magnetfelder (332, 334) und/oder eine Relativposition zwischen der zumindest zweiteiligen Gebereinrichtung (101a) und der Erfassungseinrichtung (101b) zu bestimmen.

3. Tastenschaltvorrichtung (100) gemäß Anspruch 1, **dadurch gekennzeichnet, dass** der erste Magnet (106) und der zweite Magnet (108) mit relativ zueinander entgegengesetzter Polausrichtung angeordnet sind, wobei das erste Magnetfeld (332) und das zweite Magnetfeld (334) in entgegengesetzter Richtung zueinander ausgerichtet sind.

4. Tastenschaltvorrichtung (100) gemäß einem der Ansprüche 1 bis 3, **dadurch gekennzeichnet, dass** die Erfassungseinrichtung (101b) einen ersten Sensor (110) und einen zweiten Sensor (112) aufweist, wobei der erste Sensor (110) ausgebildet ist, um ein erstes Sensorsignal abhängig von dem ersten Magnetfeld (332) und dem zweiten Magnetfeld (334) zu erzeugen, und der zweite Sensor (112) ausgebildet ist, um ein zweites Sensorsignal abhängig von dem ersten Magnetfeld (332) und dem zweiten Magnetfeld (334) zu erzeugen, wobei eine Sensierrichtung des ersten Sensors (110) einer Sensierrichtung des zweiten Sensors (112) entspricht.

5. Tastenschaltvorrichtung (100) gemäß Anspruch 4, **dadurch gekennzeichnet, dass** im Betrieb der Magnetfeldsensorvorrichtung (101) eine Magnetfeldlinie des ersten Magnetfeldes (332) und eine Magnetfeldlinie des zweiten Magnetfeldes (334) sowohl den ersten Sensor (110) als auch den zweiten Sensor (112) durchdringen.

6. Tastenschaltvorrichtung (100) gemäß einem der vorangegangenen Ansprüche, **dadurch gekennzeichnet, dass** die Sensoren (106, 108) nebeneinander in einer Sensierebene und/oder an einem gemeinsamen Trägersubstrat (330) angeordnet sind.

7. Verfahren (200) zur Bestimmung einer Relativposition zwischen einer zumindest zweiteiligen ersten Komponente (102) und einer zweiten Komponente (104), die zueinander beweglich angeordnet sind, wobei das Verfahren (200) die folgenden Schritte umfasst:

Erzeugen (210) von zumindest zwei Magnetfeldern (332, 334) mit einer an der ersten Komponente (102) angeordneten, zumindest zweiteiligen Gebereinrichtung (101a) mit mindestens zwei Magneten (106, 108) zum Erzeugen der Magnetfelder (332, 334);
Erfassen (220) der Magnetfelder (332, 334) mit einer an der zweiten Komponente (104) angeordneten Erfassungseinrichtung (101b) zur Erfassung der Magnetfelder (332, 334), die mindestens zwei Sensoren (110, 112) zum Erzeugen zumindest zweier von den Magnetfeldern (332, 334) abhängiger Sensorsignale aufweist, wobei die Magnete (106, 108) der Gebereinrichtung (101a) relativ zueinander und bezüglich der Erfassungseinrichtung (101b) beweglich angeordnet sind, wobei die Sensoren (110, 112) benachbart zueinander in einem Erfassungsbereich in einem Überschneidungsbereich der Magnetfelder (332, 334) der mindestens zwei Magnete (106, 108) angeordnet sind; und
Kombinieren (230) der Sensorsignale von der Erfassungseinrichtung (101b), um die Relativposition zwischen der ersten Komponente (102) und der zweiten Komponente (104) zu bestimmen und um eine den Magnetfeldern (332, 334) überlagerte magnetische Störgröße (336) zu bestimmen.

## Claims

1. Pushbutton key switching device (100) for a vehicle, comprising
a first component (102) having at least two selector keys which can be activated and which have the purpose of selecting drive positions;

a second component (104) for accommodating the selector keys, wherein the selector keys are movable with respect to the second component (104); and

a magnetic field sensor device (101) having at least two magnets (106, 108) for generating at least two magnetic fields (332, 334), wherein the at least two magnets (106, 108) are assigned to an at least two-part encoder device (101a), and in each case a magnet (106, 108) is arranged on a selector key, and

at least two sensors (110, 112) for generating at least two sensor signals which are dependent on the magnetic fields (332, 334), wherein the at least two sensors (110, 112) are assigned to a detection apparatus (101b) which is arranged on the second component (104), and wherein the sensors (110, 112) are arranged adjacent to one another in such a way that a detection range of each sensor (110, 112) is arranged in an overlapping region of at least two magnetic fields (332, 334) which are brought about by two adjacent magnets (106, 108) of the at least two magnets (106, 108), wherein the pushbutton key switching device (100) has an evaluation apparatus (114) which is designed to combine the sensor signals from the detection apparatus (101b) with one another, in order to determine a magnetic interference variable (336) which is superimposed on the magnetic fields (332, 334).

2. Pushbutton key switching device (100) according to Claim 1, **characterized in that** the magnetic field sensor device (101) has an evaluation apparatus (114) which is designed to combine the sensor signals from the detection apparatus (101b) with one another, in order to determine a parameter of the magnetic fields (332, 334) and/or a relative position between the at least two-part encoder device (101a) and the detection apparatus (101b).

3. Pushbutton key switching device (100) according to Claim 1, **characterized in that** the first magnet (106) and the second magnet (108) are arranged with opposing pole orientation with respect to one another, wherein the first magnetic field (332) and the second magnetic field (334) are oriented in opposite directions with respect to one another.

4. Pushbutton key switching device (100) according to one of Claims 1 to 3, **characterized in that** the detection apparatus (101b) has a first sensor (110) and a second sensor (112), wherein the first sensor (110) is designed to generate a first sensor signal as a function of the first magnetic field (332) and the second magnetic field (334), and the second sensor (112) is designed to generate a second sensor signal as a function of the first magnetic field (332) and the second magnetic field (334), wherein a sensing direction of the first sensor (110) corresponds to a sensing direction of the second sensor (112).

5. Pushbutton key switching device (100) according to Claim 4, **characterized in that** during the operation of the magnetic field sensor device (101) a magnetic field line of the first magnetic field (332) and a magnetic field line of the second magnetic field (334) penetrate both the first sensor (110) and the second sensor (112).

6. Pushbutton key switching device (100) according to one of the preceding claims, **characterized in that** the sensors (106, 108) are arranged one next to the other in a sensing plane and/or on a common carrier substrate (330).

7. Method (200) for determining a relative position between an at least two-part first component (102) and a second component (104) which are movably arranged with respect to one another, wherein the method (200) comprises the following steps:

generation (210) of at least two magnetic fields (332, 334) with an at least two-part encoder device (101a) which is arranged on the first component (102) and has at least two magnets (106, 108) for generating the magnetic fields (332, 334) ;

detecting (220) the magnetic fields (332, 334) with a detection apparatus (101b) which is arranged on the second component (104) and has the purpose of detecting the magnetic fields (332, 334) and which has at least two sensors (110, 112) for generating at least two sensor signals which are dependent on the magnetic fields (332, 334), wherein the magnets (106, 108) of the encoder device (101a) are movably arranged relative to one another and with respect to the detection apparatus (101b), wherein the sensors (110, 112) are arranged adjacent to one another in a detection range in an overlapping region of the magnetic fields (332, 334) of the at least two magnets (106, 108); and

combining (230) the sensor signals from the detection apparatus (101b), in order to determine the relative position between the first component (102) and the second component (104) and in order to determine a magnetic interference variable (336) which is superimposed on the magnetic fields (332, 334) .

## Revendications

1. Arrangement de commutation à touches (100) pour un véhicule, comprenant un premier composant (102) muni d'au moins deux touches de sélection actionnables servant à sélectionner des rapports de boîte ; un deuxième composant (104) destiné à accueillir les touches de sélection, les touches de sélection étant mobiles par rapport au deuxième composant (104) ; et un arrangement capteur de champ magnétique (101) comprenant au moins deux aimants (106, 108) destinés à générer au moins deux champs magnétiques (332, 334), les au moins deux aimants (106, 108) étant associés à un dispositif transmetteur (101a) en au moins deux parties et un aimant (106, 108) étant respectivement disposé sur une touche de sélection, et au moins deux capteurs (110, 112) destinés à générer au moins deux signaux de capteur dépendant des champs magnétiques (332, 334), les au moins deux capteurs (110, 112) étant associés à un dispositif d'acquisition (101b) qui est disposé au niveau du deuxième composant (104) et les capteurs (110, 112) étant disposés voisins l'un de l'autre de telle sorte qu'une zone d'acquisition de chaque capteur (110, 112) est disposée dans une zone de chevauchement d'au moins deux champs magnétiques (332, 334) qui sont produits par deux aimants (106, 108) voisins des au moins deux aimants (106, 108), l'arrangement de commutation à touches (100) possédant un dispositif d'interprétation (114) qui est configuré pour combiner entre eux les signaux de capteur du dispositif d'acquisition (101b) afin de déterminer une grandeur parasite magnétique (336) superposée aux champs magnétiques (332, 334).

2. Arrangement de commutation à touches (100) selon la revendication 1, **caractérisé en ce que** l'arrangement capteur de champ magnétique (101) possède un dispositif d'interprétation (114) qui est configuré pour combiner entre eux les signaux de capteur du dispositif d'acquisition (101b) afin de déterminer un paramètre des champs magnétiques (332, 334) et/ou une position relative entre le dispositif transmetteur (101a) en au moins deux parties et le dispositif d'acquisition (101b).

3. Arrangement de commutation à touches (100) selon la revendication 1, **caractérisé en ce que** le premier aimant (106) et le deuxième aimant (108) sont disposés avec une orientation polaire opposée l'un par rapport à l'autre, le premier champ magnétique (332) et le deuxième champ magnétique (334) étant orientés dans des directions opposées l'un par rapport à l'autre.

4. Arrangement de commutation à touches (100) selon l'une des revendications 1 à 3, **caractérisé en ce que** le dispositif d'acquisition (101b) possède un premier capteur (110) et un deuxième capteur (112), le premier capteur (110) étant configuré pour générer un premier signal de capteur en fonction du premier champ magnétique (332) et du deuxième champ magnétique (334), et le deuxième capteur (112) étant configuré pour générer un deuxième signal de capteur en fonction du premier champ magnétique (332) et du deuxième champ magnétique (334), une direction de détection du premier capteur (110) correspondant à une direction de détection du deuxième capteur (112).

5. Arrangement de commutation à touches (100) selon la revendication 4, **caractérisé en ce que** lors du fonctionnement de l'arrangement capteur de champ magnétique (101), une ligne de champ magnétique du premier champ magnétique (332) et une ligne de champ magnétique du deuxième champ magnétique (334) traversent à la fois le premier capteur (110) et le deuxième capteur (112).

6. Arrangement de commutation à touches (100) selon l'une des revendications précédentes, **caractérisé en ce que** les capteurs (106, 108) sont disposés l'un à côté de l'autre dans un plan de détection et/ou sur un substrat porteur (330) commun.

7. Procédé (200) de détermination d'une position relative entre au moins un premier composant (102) et un deuxième composant (104), qui sont disposés mobiles l'un par rapport à l'autre, le procédé (200) comprenant les étapes suivantes :

   génération (210) d'au moins deux champs magnétiques (332, 334) avec un dispositif transmetteur (101a) en au moins deux parties, disposé sur le premier composant (102), comprenant au moins deux aimants (106, 108) destinés à générer les champs magnétiques (332, 334) ; détection (220) des champs magnétiques (332, 334) avec un dispositif d'acquisition (101b) destiné à détecter les champs magnétiques (332, 334) et disposé au niveau du deuxième composant (104), lequel possède au moins deux capteurs (110, 112) destinés à générer au moins deux signaux de capteur dépendant des champs magnétiques (332, 334), les aimants (106, 108) du dispositif transmetteur (101a) étant disposés mobiles l'un par rapport à l'autre et par rapport au dispositif d'acquisition (101b), les capteurs (110, 112) étant disposés voisins l'un de l'autre dans une zone d'acquisition dans une zone de chevauchement des champs magnétiques (332, 334) des au moins deux aimants (106, 108) ; et

combinaison (230) des signaux de capteur du dispositif d'acquisition (101b) afin de déterminer la position relative entre le premier composant (102) et le deuxième composant (104) et afin de déterminer une grandeur parasite magnétique (336) superposée aux champs magnétiques (332, 334).

Fig. 1

Fig. 2

Fig. 3A

Fig. 3B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1777501 A1
- EP 0175061 A
- DE 102007052146